Europäisches Patentamt

European Patent Office

Office européen des brevets

(11) Veröffentlichungsnummer: **0 178 591**

**B1**

(12) **EUROPÄISCHE PATENTSCHRIFT**

(45) Veröffentlichungstag der Patentschrift:
31.05.89

(21) Anmeldenummer: 85112841.3

(22) Anmeldetag: 10.10.85

(51) Int. Cl.⁴: **H 05 B 41/02,** H 01 F 17/06

(54) **Anordnung von Schaltungsbauteilen eines elektronischen Vorschaltgerätes zum Betreiben einer Niederdruckentladungslampe.**

(30) Priorität: 12.10.84 DE 3437527

(43) Veröffentlichungstag der Anmeldung:
23.04.86 Patentblatt 86/17

(45) Bekanntmachung des Hinweises auf die Patenterteilung:
31.05.89 Patentblatt 89/22

(84) Benannte Vertragsstaaten:
**CH DE FR GB IT LI**

(56) Entgegenhaltungen:
FR-A-2 394 878
GB-A-1 065 676

(73) Patentinhaber: **Patent-Treuhand-Gesellschaft für elektrische Glühlampen mbH, Hellabrunner Strasse 1, D-8000 München 90 (DE)**

(72) Erfinder: **Fähnrich, Hans-Jürgen, Dipl.-Ing., Hofheimerstrasse 11, D-8000 München 60 (DE)**
Erfinder: **Rasch, Erhard, Dipl.-Phys., Egerweg 2, D-8012 Ottobrunn (DE)**

EP 0 178 591 B1

## Beschreibung

Die Erfindung betrifft eine Anordnung von Schaltungsbauteilen mit den im Oberbegriff des Hauptanspruchs bezeichneten Merkmalen.

Solche Ansteuerschaltungen sind z. B. in der druckschriftlichen Veröffentlichung "Elektronikschaltungen" von Walter Hirschmann, Berlin/München, Siemens-Aktiengesellschaft, 1982, auf den Seiten 147 und 148 beschrieben. Der hier verwendete Ringkern des Sättigungstransformators weist einen Außendurchmesser von nur ca. 12 mm auf; der Durchmesser des Kernquerschnitts beträgt nur ca. 5 mm. In der Praxis hat sich gezeigt, daß es insbesondere für die Fertigung von größeren Stückzahlen sehr zeitaufwendig ist, bei derart kleinen Kernquerschnitten die erforderlichen Einzelwindungen der induktiven Widerstände aufzubringen.

In der FR-A-2 394 878 ist eine vereinfachte Möglichkeit aufgeführt, einzelne und auch mehrere Windungen in Hybridtechnik auf einen Ringkerntransformator aufzubringen. Hierbei sind auf einer ebenen Oberfläche eine Vielzahl von Leiterbahnen aufgebracht. Die U-förmig gebogenen Metalldrahtleiter sind mit den Enden dieser Leiterbahnen derart verbunden, daß diese zusammen eine fortlaufende Wicklung des Hybridtransformators ergeben.

Aufgabe der Erfindung ist es, die Bauteilanordnung für die Ansteuerschaltung einer Niederdruckentladungslampe derart zu gestalten, daß diese mechanisiert in einfacher Weise und platzsparend auf einer Platine anzuordnen sind. Die sonst bei Niederdruckentladungslampen zu beobachtende Verzögerung des Lampenanlaufs bis zum Erreichen der endgültigen elektrischen Daten soll verkürzt werden, ohne andere elektrische und schaltungstechnische Daten negativ zu verändern.

Diese Aufgabe wird bei einer Anordnung der Schaltungsbauteile gemäß dem kennzeichnenden Teil des Hauptanspruchs gelöst. Die weitere Ausgestaltung der Erfindung ist den Unteransprüchen entnehmbar. Die Integration vom ohmschen Widerstand und induktiven Widerstand in einem einzigen Bauteil wirkt sich auf die Platine als äußerst platzsparend aus. Durch die stehende Anordnung der ohmschen Widerstände im Innern des ringförmigen Transformatorkerns, geben diese den Raum, den sie sonst auf der Platine außerhalb des Transfornatorkerns und liegend einnahmen, gänzlich frei. Als weiterer wesentlicher Vorteil ergibt sich aus der zuvor beschriebenen Anordnung, daß der ringförmige Transformatorkern neben seiner Eigenerwärmung, die er durch seinen normalen Betrieb erfährt, darüber hinaus durch die von den ohmschen Widerständen abgegebene Wärme zusätzlich aufgeheizt wird, so daß dieser schnell seine endgültige Temperatur und die zu betreibende Niederdruckentladungslampe damit schnell ihre endgültigen elektrischen Daten erreicht.

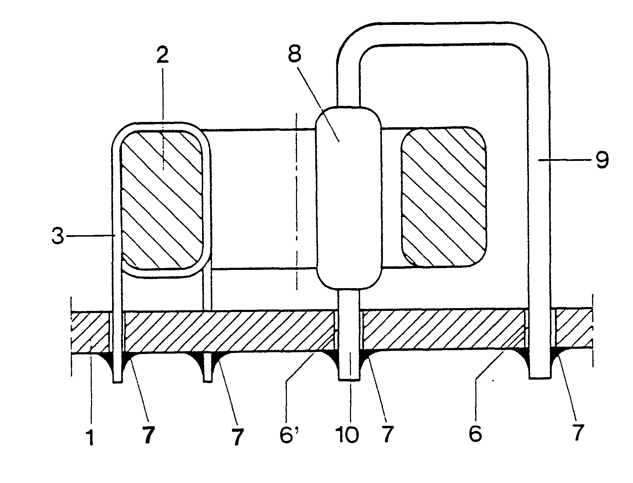

Die Erfindung wird nachstehend anhand einer schematisch dargestellten Figur näher erläutert. Die einzige Figur zeigt eine einzelne Windung, wobei der induktive Niderstand der Sekundärwicklung durch die gebogenen Anschlußdrähte eines ohmschen Niderstands gebildet wird.

Auf einer an sich bekannten Platine 1 aus Kunststoff, die auf der Unterseite mit Leiterbahnen (nicht dargestellt) versehen ist, ist der ringförmige Transformatorkern 2 eines Sättigungstransformators angeordnet. Der Transformatorkern 2 wird durch die aus mehreren Windungen bestehende Primärwicklung 3 gehalten. Die Sekundärwicklung des Trnasformators besteht nur aus einer einzigen Windung, die durch die Anschlußdrähte 9 und 10 des ohmschen Widerstandes 8 gebildet wird. Dieser ist innerhalb des Transformatorkerns 2 senkrecht stehend angeordnet, wobei dessen erster Anschluß 9 etwa U-förmig um den Ringkern 2 herum nach außen gebogen und durch eine erste Öffnung 6 geführt ist. Der zweite Anschluß 10 des Widerstands 8 ist direkt durch eine andere Öffnung 6' auf die dem Ringkern 2 abgewandte Seite der Platine 1 geführt. Beide Anschlußdrähte 9, 10 des Widerstands 8 sind dann auf der Unterseite der Platine 1 mittels Lot 7 mit der zugehörigen Leiterbahn elektrisch-leitend verbunden. Obwohl hier nur die Anordnung eines Widerstands 8 in Verbindung mit einer einzelnen Sekundärwindung des Transformators beschrieben und in der Zeichnung dargestellt wurde, befinden sich in der Praxis zwei derartige und zur Ansteuerschaltung der Niederdruckentladungslampe erforderliche ohmsche Widerstände 8 innerhalb des ringförmigen Transformatorkerns 2. Die Wärmeentwicklung dieser beiden Widerstände 8, die schaltungsgemäß jeweils mit einem Transistor der Ansteuerschaltung verbunden sind, wird von dem Transformatorkern 2 aufgenommen. Erst hierdurch werden die zuvor beschriebenen Vorteile, insbesondere hinsichtlich des gegenüber bei Normalschaltungsanordnungen beschleunigten Anlaufs und des Erreichens der endgültigen elektrischen Lampendaten, ermöglicht.

## Patentansprüche

1. Anordnung von Schaltungsbauteilen für ein elektronisches Vorschaltgerät zum Betreiben einer Niederdruckentladungslampe, das eine Platine (1) mit aufgedruckten Leiterbahnen sowie ein Paar von Transistoren und einen Transformator als Schaltungsbauteile aufweist, wobei der Transformatorkern (2) mit einer Primärwicklung (3) versehen ist, die mit den zugehörigen Leiterbahnen mittels Lot (7) elektrisch verbunden ist und die den Transformatorkern (2) auf der Platine mechanisch haltert, und der Transformatorkern (2) weiterhin zwei voneinander getrennte, aus jeweils einer Windung bestehende induktive Widerstände als Sekundärwicklung aufweist, von denen jede mit einem Transistor verbunden ist, dadurch gekennzeichnet, daß jeder induktive Widerstand durch die Anschlußdrähte (9, 10) eines ohmschen Widerstands (8) gebildet wird, die den Transformatorkern (2) im wesentlichen U-förmig umgeben und die auf der Platine (1) mittels Lot (7) befestigt sind, wobei jeder ohmsche Widerstand (8) gleichzeitig als Ansteuerung für einen Transistor vorgesehen ist.

2. Anordnung nach Anspruch 1, dadurch gekennzeichnet, daß der Transformatorkern (2) eine ringförmige Gestalt aufweist und die Anschlußdrähte (9, 10) jedes Widerstands (8) innerhalb bzw. außerhalb des ringförmigen Transformatorkerns (2) angeordnet sind.

3. Anordnung nach Anspruch 1 und 2, dadurch gekennzeichnet, daß die Widerstände (8) in unmittelbarer Nachbarschaft des Transformatorkerns (2) angeordnet sind.

4. Anordnung nach Anspruch 1 bis 3, dadurch gekennzeichnet, daß die Widerstände (8) innerhalb des ringförmigen Transformatorkerns (2) stehend angeordnet sind.

### Claims

1. An arrangement of circuit components for an electronic ballast for the operation of a low pressure discharge lamp which comprises a plate (1) with printed conductor paths and a pair of transistors and a transformer as circuit components, where a transformer core (2) is provided with a primary winding (3) which is electrically connected to the associated conductor paths by means of solder (7) and which mechanically supports the transformer core (2) of the plates, and where the transformer core (2) also comprises two inductive impedances which are separate from one another, each consist of one turn, and serve as secondary winding, each of which inductive impedances is connected to a transistor, characterised in that each inductive impedance is formed by the terminal wires (9, 10) of an ohmic impedance (8) which surrounds the transformer core (2) in a basic U-formation and are attached to the plate (1) by means of solder (7), where each ohmic impedance (8) simultaneously serves as drive means for a transistor.

2. An arrangement as claimed in claim 1, characterised in that the transformer core (2) is of ring-shaped formation and the terminal wires (9, 10) of each impedance (8) are arranged inside and outside the ring-shaped transformer core (2) respectively.

3. An arrangement as claimed in claims 1 and 2, characterised in that the impedances (8) are arranged in the direct vicinity of the transformer core (2).

4. An arrangement as claimed in claims 1 to 3, characterised in that the impedances (8) are arranged vertically inside the ring-shaped transformer core (2).

### Revendications

1. Montage de composants de circuit pour un ballast électronique servant au fonctionnement d'une lampe à décharge basse pression, comprenant une platine (1) avec des pistes conductives imprimées ainsi qu'une paire de transistors et un transformateur en tant que composants de circuit, le noyau (2) du transformateur étant pourvu d'un enroulement primaire (3) relié électriquement aux pistes conductives correspondantes par des dépôts de soudure (7), l'enroulement primaire (3) maintenant le noyau (2) du transformateur mécaniquement sur la platine et le noyau (2) du transformateur présentant, en outre, en tant qu'enroulement secondaire, deux résistances inductives séparées l'une de l'autre et formant chacune une spire, chaque résistance étant reliée à un transistor, caractérisé en ce que chaque résistance inductive est formée par les fils de connexion (9, 10) d'une résistance ohmique (8), qui entourent le noyau (2) du transformateur essentiellement en forme de U et sont fixés sur la platine (1) par des dépôts de soudure (7), chaque résistance ohmique (8) étant prévue en même temps comme élément d'attaque pour un transistor.

2. Montage selon la revendication 1, caractérisé en ce que le noyau (2) du transformateur possède une forme annulaire et les fils de connexion (9, 10) de chaque résistance (8) sont disposés à l'intérieur et à l'extérieur du noyau annulaire (2) du transformateur.

3. Montage selon les revendications 1 et 2, caractérisé en ce que les résistances (8) sont disposées à proximité immédiate du noyau (2) du transformateur.

4. Montage selon les revendications 1 à 3, caractérisé en ce que les résistances (8) sont disposées débout à l'intérieur du noyau annulaire (2) du transformateur.